# EUROPÄISCHE PATENTSCHRIFT

(11) **EP 2 651 535 B1**
(45) Veröffentlichungstag und Bekanntmachung des Hinweises auf die Patenterteilung: **01.11.2017**
(21) Anmeldenummer: 11796710.9
(22) Anmeldetag: 16.12.2011
(51) Int. Cl.: B01D 53/26, H01M 2/12, H05K 5/02

(54) **DRUCKAUSGLEICHSELEMENT, BATTERIE MIT DRUCKAUSGLEICHSELEMENT UND KRAFTFAHRZEUG MIT EINER ENTSPRECHENDEN BATTERIE**
PRESSURE EQUALIZING ELEMENT, BATTERY HAVING A PRESSURE EQUALIZING ELEMENT, AND MOTOR VEHICLE HAVING A CORRESPONDING BATTERY
ÉLÉMENT DE COMPENSATION DE PRESSION, BATTERIE DOTÉE D'UN ÉLÉMENT DE COMPENSATION DE PRESSION ET VÉHICULE AUTOMOBILE ÉQUIPÉ D'UNE BATTERIE CORRESPONDANTE

(30) Priorität: 17.12.2010 DE 102010063423
(43) Veröffentlichungstag der Anmeldung: 23.10.2013
(73) Patentinhaber: Robert Bosch GmbH, 70442 Stuttgart (DE); SAMSUNG SDI CO., LTD., Yongin-si, Gyeonggi-do 446-577 (KR)
(72) Erfinder: GLESS, Michael, 70437 Stuttgart-Zazenhausen (DE); FRIES, Romuald, 71287 Weissach (DE); REITZLE, Alexander, 89231 Neu-Ulm (DE); ZIMMERMANN, Ulrich, 74394 Hessigheim (DE)
(74) Vertreter: Bee, Joachim
(86) Internationale Anmeldenummer: PCT/EP2011/073007
(87) Internationale Veröffentlichungsnummer: WO 2012/080445

(56) Entgegenhaltungen:
- EP-A2- 1 818 609
- WO-A1-2011/141199
- DE-A1-102008 034 698
- FR-A1- 2 778 584
- GB-A- 2 177 016
- US-A1- 2005 157 514

## Beschreibung

Die vorliegende Erfindung betrifft ein Druckausgleichselement für ein Gehäuse, mit einer Kopfsektion und einer Rumpfsektion und einem durch die Kopfsektion und die Rumpfsektion verlaufenden, luftdurchgängigen Kanal. Zudem betrifft die vorliegende Erfindung eine Batterie mit diesem Druckausgleichselement und ein Kraftfahrzeug mit dieser Batterie.

### Stand der Technik

Druckausgleichselemente sind bekannt. Sie dienen einer Belüftung und Entlüftung von abgedichteten Gehäusen, um Druckdifferenzen zwischen einem vom Gehäuse eingeschlossenen Innenraum und der Umgebung des Gehäuses zu vermeiden und einer Kondensatbildung im Innenraum vorzubeugen.

Aus der DE 10 2006 053 113 A1 geht ein Druckausgleichselement für ein abgedichtetes Gehäuse, insbesondere für ein Gehäuse, das eine elektrische Schaltung aufnimmt, hervor, welches im Bereich hoher mechanischer und fluidischer Belastung einen sicheren Druckausgleich bei gleichzeitiger Dichtheit gewährleisten soll. Das Druckausgleichselement weist dazu eine von einer Haltevorrichtung gehaltene semipermeable Membran und mindestens ein Dichtungselement zur Abdichtung gegenüber dem Gehäuse auf, wobei die Haltevorrichtung von dem Dichtelement gebildet ist.

Aus der DE 10 2008 034698 A1 ist auch ein Druckausgleichselement nach dem Oberbegriff des Anspruchs 1 bekannt.

### Offenbarung der Erfindung

Erfindungsgemäß wird für ein Gehäuse ein Druckausgleichselement zur Verfügung gestellt, welches eine Kopfsektion und eine Rumpfsektion und einen durch die Kopfsektion und die Rumpfsektion verlaufenden, luftdurchgängigen Kanal aufweist. Dabei ist im Kanal ein Trockenelement mit einem durch den Kanal strömende Luft Feuchtigkeit entziehenden Trockenmittel angeordnet.

Hiermit ist vorteilhaft ein Druckausgleichselement mit verbesserten Lufttrocknungseigenschaften bereitgestellt. Wie bekannte Druckausgleichselemente bietet es vielfache Einsatzmöglichkeiten. Es ist zudem vergleichsweise kostengünstig herzustellen.

Zusätzlich bietet das erfindungsgemäße Druckausgleichselement mit dem Trockenmittel eine schalldämpfende Funktion. Vorgänge innerhalb eines mit dem Druckausgleichselement versehenen Gehäuses dringen so weniger stark als bei herkömmlichen Druckausgleichselementen an die Umgebung.

In einer bevorzugten Ausgestaltung der Erfindung ist vorgesehen, dass das Trockenelement einen Indikator zur Information über eine Aufnahmekapazität des Trockenmittels aufweist. Vorteilhaft kann hiermit eine Information über den Zustand des Trockenelements leicht erhalten und eine Sättigung mit Feuchtigkeit erkannt werden.

In einer weiteren bevorzugten Ausgestaltung der Erfindung ist vorgesehen, dass der Indikator ein elektronischer Sensor ist, der mit einem elektronischen Managementsystem verbindbar ist. Hiermit ist es vorteilhaft ermöglicht, mittels elektronischer Zustandsanzeigen über den Zustand des Trockenmittels zu informieren. Zudem können vorteilhaft automatische Prozesse entsprechend dem Zustand des Trockenmittels eingeleitet werden, wie beispielsweise Trocknungsprozesse.

In einer weiteren bevorzugten Ausgestaltung der Erfindung ist vorgesehen, dass der Indikator eine in Abhängigkeit der Aufnahmekapazität des Trockenmittels variable Erscheinung aufweist. Hiermit ist es vorteilhaft ermöglicht, ohne periphere Vorrichtungen, mit bloßem Auge die Aufnahmekapazität des Trockenmittels zu erkennen.

Bevorzugt sind dabei sich in Abhängigkeit des Zustands des Trockenmittels verfärbende Flächen eingesetzt. Diese Flächen können Flächen des Trockenmittels selbst oder Flächen der das Trockenmittel umgebenden Verpackung sein. Durch eine simple Aussparung, Bohrung oder eine Sichtscheibe ist die Verfärbung für einen Betrachter von der Umgebung her erkennbar.

In einer weiteren bevorzugten Ausgestaltung der Erfindung ist vorgesehen, dass im Kanal in Richtung von Kopfsektion zur Rumpfsektion hinter dem Trockenelement ein Ventil angeordnet ist. Hiermit ist es vorteilhaft ermöglicht, durch Schließen des Ventils einen Luftfluss durch den Kanal zu stoppen. In einem mittels des Druckausgleichselements be- und entlüfteten Innenraum kann durch Schließen des Ventils bei entsprechenden äußeren Bedingungen ein bestimmter Druck und/oder eine bestimmte Temperatur erzeugt werden, wodurch bei Öffnung des Ventils ein Strom warmer, in die Umgebung entweichender Luft erzeugbar ist, welcher für eine Durchspülung des Trockenmittels nutzbar ist.

In einer weiteren bevorzugten Ausgestaltung der Erfindung ist vorgesehen, dass das Ventil elektronisch steuerbar und mit einem Managementsystem verbindbar ist. Hiermit ist vorteilhaft eine Steuerung des Ventils beispielsweise mittels eines Batteriemanagementsystems oder eines Temperaturmanagementsystems ermöglicht. Ein Öffnen und Schließen kann so vorteilhaft automatisiert erfolgen und damit auch eine Luftspülung zur Trocknung des Trockenmittels somit zur Regeneration des Trockenmittels durchgeführt werden.

In einer weiteren bevorzugten Ausgestaltung der Erfindung ist vorgesehen, dass zumindest die Rumpfsektion ein Außengewinde aufweist und die Kopfsektion eine derartige Gestalt aufweist, dass eine formschlüssige Verbindung mit einem Werkzeug herstellbar ist. Hiermit ist vorteilhaft eine schnelle und kostengünstige Montage des erfindungsgemäßen Druckausgleichselements ermöglicht. Zudem ist eine Implementierung in ein Gehäuse hierdurch mit einfachen Mitteln, wie einem Loch mit Innengewinde, zu erreichen.

Die Gestalt der Kopfsektion ist dabei bevorzugt im Wesentlichen die eines Schraubenkopfes. Damit ist eine Montage bevorzugt mit üblichen Werkzeugen zu verrichten.

Das erfindungsgemäße Druckausgleichselement kann in verschiedenen Systemen angewandt werden, beispielsweise bei Scheinwerfern, Kameraobjektiven oder bei Transportkisten. Bevorzugt ist das erfindungsgemäße Druckausgleichselement in ein Elektronikgehäuse insbesondere in ein Batteriegehäuse integriert.

Erfindungsgemäß wird somit zudem eine Batterie mit einem Gehäuse bereitgestellt, mit einem im Gehäuse der Batterie angeordneten Druckausgleichselement in einer der zuvor genannten Ausgestaltungen. Dabei ist die Rumpfsektion des Druckausgleichselements einem vom Gehäuse eingeschlossenen Innenraum und die Kopfsektion des Druckausgleichselements einer Umgebung des Gehäuses zugewandt. Da gerade in Batteriegehäusen durch die Aktivität der Batterie ein zuverlässiger Druckausgleich erfolgen und gleichzeitig der Innenraum trocken gehalten werden muss, kommen die Vorteile des erfindungsgemäßen Druckausgleichselements besonders zum Tragen.

Die Ausgestaltungsvariante mit elektronischem Sensor und elektronisch steuerbarem Ventil eignet sich dabei besonders für Verbauungssituationen, in denen die Batterie schwieriger zugänglich untergebracht ist, beispielsweise in Kraftfahrzeugen.

Der Begriff Batterie schließt in dieser Anmeldung auch Batteriesysteme, Akkumulatorbatterien, Akkumulatoren, Akkumulatorsysteme, insbesondere Li-Ionen-Systeme oder Li-Polymer-Ionen-Systeme mit ein. Die Batterie ist dabei bevorzugt eine Li-Ionen-Batterie.

Erfindungsgemäß wird weiterhin ein Kraftfahrzeug bereitgestellt, mit einer Batterie, welche ein Druckausgleichselement in einer der zuvor genannten Ausgestaltungen umfasst, wobei die Batterie mit einem Antriebssystem des Kraftfahrzeugs verbunden ist. Die Vorteile der erfindungsgemäßen Batterie als Bauteil kommen so auch dem Kraftfahrzeug als Baugruppe zugute.

Vorteilhafte Weiterbildungen der Erfindung sind in den Unteransprüchen angegeben und in der Beschreibung charakterisiert.

### Zeichnungen

Die Erfindung wird anhand von zwei Zeichnungen und der nachfolgenden Beschreibung näher erläutert. Es zeigen:
Figur 1 ein erfindungsgemäßes Druckausgleichselement und
Figur 2 das Druckausgleichselement in einer Schnittdarstellung.

### Ausführungsformen der Erfindung

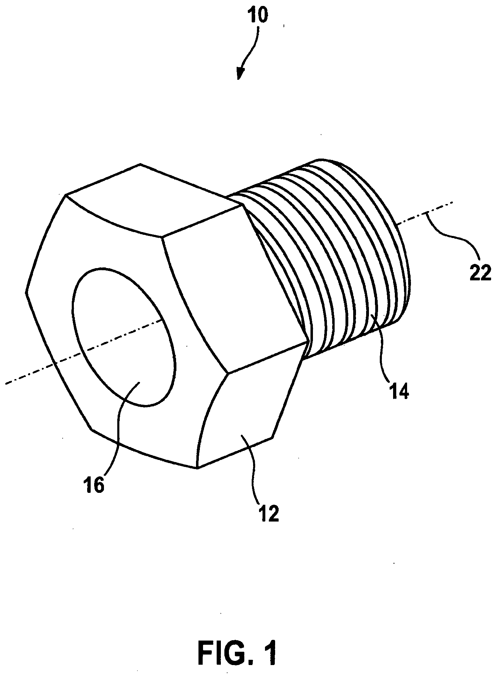

Figur 1 zeigt beispielhaft aber nicht beschränkend ein erfindungsgemäßes Druckausgleichselement 10 zur Belüftung eines Gehäuses. Das Druckausgleichselement 10 ist dazu in eine Wand des Gehäuses zu montieren oder in die Wand des Gehäuses integriert. In der abgebildeten Ausgestaltung weist es im Wesentlichen die Form einer Schraube mit Sechskantkopf und Gewindeschaft auf. Dabei ist der Schraubenkopf von einer Kopfsektion 12 gebildet und der Schaft von einer Rumpfsektion 14. Erfindungsgemäß kann das Druckausgleichselement 10 jedoch in jeder anderen bekannten Form von Druckausgleichselementen ausgestaltet sein.

Wesentlich ist, dass die Kopfsektion 12 in montiertem Zustand des Druckausgleichselements 10 der Teil des Druckausgleichselements 10 ist, der der Umgebung des Gehäuses zugewandt ist und die Rumpfsektion 14 der Teil ist, der einem Innenraum des Gehäuses zugewandt ist. Die Kopfsektion 12 und die Rumpfsektion 14 können dabei auch aus einem entlang der Längsachse 22 gleichartig ausgeformten Körper bestehen. Die Kopfsektion 12 und die Rumpfsektion 14 können somit auch die gleiche Gestalt aufweisen.

Die in Figur 1 gezeigte Ausgestaltung des erfindungsgemäßen Druckausgleichselements 10 in der Form einer Schraube mit Sechskantkopf und Gewindeschaft eignet sich zur einfachen Montage in ein Gehäuse dadurch, dass das Druckausgleichselement 10 in eine entsprechende Gewindebohrung ins Gehäuse mittels eines entsprechenden Sechskantschlüssels einschraubbar ist. Nach der Montage ist die Kopfsektion 12 an einer Außenseite des Gehäuses und die Rumpfsektion 14 ist an einer Innenseite des Gehäuses angeordnet.

Um einen Druckausgleich zwischen einem vom Gehäuse eingeschlossenen Innenraum und der Umgebung realisieren zu können, verfügt das Druckausgleichselement 10 über einen Kanal 16, der einen Durchgang vom Innenraum zur Umgebung schafft. Der Kanal 16 kann dabei abweichend von der Ausgestaltung gemäß Figur 1 auch dezentral angeordnet sein und/oder Bögen aufweisen. Es ist zudem möglich, dass der Kanal 16 aus mehreren miteinander verbundenen oder nichtverbundenen Strängen gebildet ist.

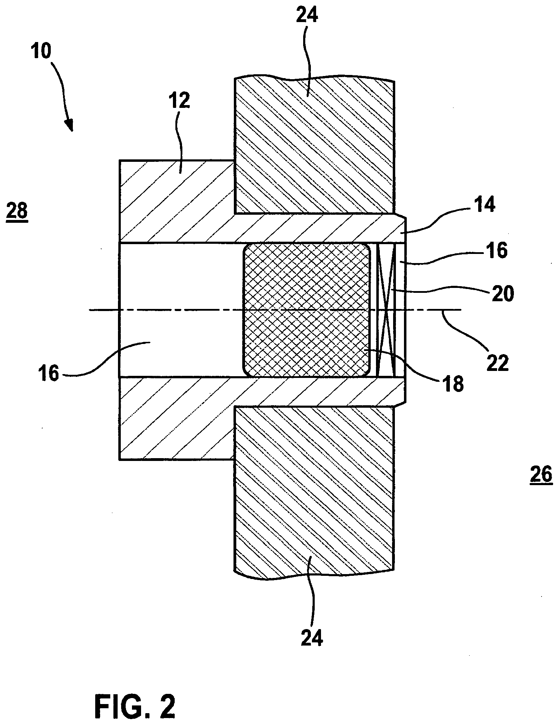

Figur 2 zeigt in einer Schnittansicht die zuvor beschriebene beispielhafte und nicht beschränkende Ausführung eines erfindungsgemäßen Druckausgleichselements 10 in einer Einbausituation. Das Druckausgleichselement 10 ist dabei in einer Gehäusewand 24 eines Gehäuses angebracht. Die Gehäusewand 24 trennt einen Innenraum 26 des Gehäuses von der Umgebung 28 des Gehäuses.

In der Schnittdarstellung ist der durch die Kopfsektion 12 und die Rumpfsektion 14 verlaufende Kanal 16 sichtbar. Der Kanal 16 verbindet den Innenraum 26 des Gehäuses mit der Umgebung 28. Dabei ist die Kopfsektion 12 zur Umgebung 28 gerichtet, und die Rumpfsektion 14 ist zum Innenraum 26 gerichtet.

Innerhalb des Kanals 16 ist ein Trockenelement 18 angeordnet. Passieren Luftströme den Kanal 16, so durchdringen diese auch das Trockenelement 18. Im Trockenelement 18 ist ein Trockenmittel angeordnet, welches der durchströmenden Luft Feuchtigkeitsanteile entzieht, indem es diese an sich bindet. Aus der Umgebung 28 in den Innenraum 26 strömende Luft wird so entfeuchtet beziehungsweise getrocknet.

Das Trockenelement 18 ist mit geeigneten Mitteln im Kanal 16 befestigt. Es weist eine das Trockenmittel einschließende luftdurchlässige Verpackung auf. Das Trockenelement 18 kann erfindungsgemäß auch mehrere Verpackungen mit Trockenmittel aufweisen. Das Trockenmittel zeichnet sich dabei durch hygroskopische Eigenschaften aus. Es bindet Feuchtigkeitsbestandteile der Luft vorzugsweise durch reversible physikalische Prozesse.

Das Trockenelement 18 weist in bevorzugter Ausgestaltung einen Indikator auf, der über eine Aufnahmekapazität des Trockenmittels informiert. Beispielsweise besteht die Möglichkeit, dass als Indikator eine Verfärbung des Trockenmittels und/oder der Verpackung an zumindest einer Stelle, welche von der Umgebung 28 her erkennbar ist, fungiert. Eine bestimmte Farbe, ein bestimmter Farbton oder eine bestimmte erscheinende Kennzeichnung stehen für einen bestimmten Sättigungsgrad. Das Trockenelement 18 selbst dient hierbei als optische Anzeige und lässt nötige manuelle Eingriffe erkennen. So kann beispielsweise das Trockenmittel ausgetauscht oder ein Lüftungs- beziehungsweise Austrocknungsvorgang des Trockenmittels vom Nutzer eingeleitet werden, wenn eine entsprechend hohe Feuchtigkeit im Trockenmittel angezeigt wird.

Alternativ zum Farbänderungsindikator kann das Trockenelement 18 mit zumindest einem elektronischen Sensor ausgestattet sein, der die Feuchtigkeit des Trockenmittels erkennt. Der Sensor kann die ermittelten Daten an ein elektronisches Managementsystem, beispielsweise ein Batteriemanagementsystem oder an ein Thermo-Managementsystem weiterleiten, welches eine Überschreitung einer bestimmten Trockenmittelfeuchtigkeit mittels eines bestimmten Signals anzeigt oder nötige Maßnahmen automatisch einleitet. Hierbei kann eine optische Anzeige in einem für den Nutzer augenfälligeren Bereich, beispielsweise in einem Display eines Bordcomputers eines Kraftfahrzeugs erzeugt werden. Auch ein akustisches Signal könnte von der elektronischen Managementeinheit als Indikation abgegeben werden.

Zur Trocknung des Trockenmittels könnte das Trockenmittel automatisch mit warmer Luft durchspült werden. Dazu ist die von der elektronischen Vorrichtung innerhalb des Gehäuses erzeugte Wärme verwendbar. Das erfindungsgemäße Druckausgleichselement umfasst dazu alternativ ein Ventil 20, welches in Richtung von Kopfsektion 12 zur Rumpfsektion 14 hinter dem Trockenelement 18 angeordnet ist. Dieses Ventil 20 ist bevorzugt ebenfalls vom dem elektronischen Managementsystem steuerbar, so dass es geschlossen gehalten werden kann, bis im Innenraum 26 eine bestimmte Temperatur und damit verbunden ein bestimmter Druck erreicht ist, um einen Strom warmer Luft vom Innenraum 26 durch das Druckausgleichselement 10 und damit durch das Trockenmittel zur Umgebung 28 zu erzeugen.

Das Ventil 20 dient zudem dazu, um in einem passiven Zustand der im Gehäuse untergebrachten elektronischen Vorrichtung bei feuchter Umgebung 28 eine Diffusion von Wassermolekülen durch das Druckausgleichselement 10 zu vermeiden. Ein beispielhafter Anwendungsfall hierfür ist eine Batterie in einem parkenden Kraftfahrzeug, die weder geladen noch entladen wird.

Das erfindungsgemäße Druckausgleichselement 10 kann in verschiedenen Systemen angewandt werden, beispielsweise bei Scheinwerfern, Kameraobjektiven, Transportkisten oder bevorzugt bei Elektronikgehäusen insbesondere Batteriegehäusen.

## Patentansprüche

1. Druckausgleichselement (10) für ein Gehäuse, mit einer Kopfsektion (12) und einer Rumpfsektion (14) und einem durch die Kopfsektion (12) und die Rumpfsektion (14) verlaufenden, luftdurchgängigen Kanal (16), **dadurch gekennzeichnet, dass** im Kanal (16) ein Trockenelement (18) mit einem durch den Kanal (16) strömende Luft Feuchtigkeit entziehenden Trockenmittel angeordnet ist, wobei im Kanal (16) in Richtung von Kopfsektion (12) zur Rumpfsektion (14) hinter dem Trockenelement (18) ein Ventil (20) angeordnet ist.

2. Druckausgleichselement (10) nach Anspruch 1, wobei das Trockenelement (18) einen Indikator zur Information über eine Aufnahmekapazität des Trockenmittels aufweist.

3. Druckausgleichselement (10) nach Anspruch 2, wobei der Indikator ein elektronischer Sensor ist, der mit einem elektronischen Managementsystem verbindbar ist.

4. Druckausgleichselement (10) nach Anspruch 2, wobei der Indikator eine in Abhängigkeit der Aufnahmekapazität des Trockenmittels variable Erscheinung aufweist.

5. Druckausgleichselement (10) nach Anspruch 1, wobei das Ventil (20) elektronisch steuerbar und mit einem Managementsystem verbindbar ist.

6. Druckausgleichselement (10) nach einem der Ansprüche 1 bis 5, wobei zumindest die Rumpfsektion (14) ein Außengewinde aufweist und die Kopfsektion (12) eine derartige Gestalt aufweist, dass eine formschlüssige Verbindung mit einem Werkzeug herstellbar ist.

7. Batterie mit einem Gehäuse mit einer Gehäusewand (24), wobei in der Gehäusewand (24) ein Druckausgleichselement (10) nach einem der Ansprüche 1 bis 6 angeordnet ist, wobei die Rumpfsektion (14) des Druckausgleichselements (10) einem vom Gehäuse eingeschlossenen Innenraum (26) und die Kopfsektion (12) des Druckausgleichselements (10) einer Umgebung (28) des Gehäuses zugewandt ist.

8. Kraftfahrzeug mit einer Batterie nach Anspruch 7, wobei die Batterie mit einem Antriebssystem des Kraftfahrzeugs verbunden ist.

## Claims

1. Pressure equalizing element (10) for a housing, said pressure equalizing element having a head section (12) and a body section (14) and a duct (16), through which duct air can pass and which duct extends through the head section (12) and the body section (14), **characterized in that** a drying element (18) having a drying agent that draws moisture from the air flowing through the duct is arranged in the duct (16), wherein a valve (20) is arranged in the duct (16) in the direction from the head section (12) towards the body section (14) downstream of the drying element (18).

2. Pressure equalizing element (10) according to Claim 1, wherein the drying element (18) comprises an indicator for providing information regarding an absorption capacity of the drying means.

3. Pressure equalizing element (10) according to Claim 2, wherein the indicator is an electronic sensor that can be connected to an electronic management system.

4. Pressure equalizing element (10) according to Claim 2, wherein the appearance of the indicator changes depending upon the absorption capacity of the drying agent.

5. Pressure equalizing element (10) according to Claim 1, wherein the valve (20) can be electronically controlled and can be connected to a management system.

6. Pressure equalizing element (10) according to any one of Claims 1 to 5, wherein at least the body section (14) comprises an external thread and the form of the head section (12) is such that a form-locking connection can be produced using a tool.

7. Battery having a housing having a housing wall (24) wherein a pressure equalizing element (10) according to any one of Claims 1 to 6 is arranged in the housing wall (24), wherein the body section (14) of the pressure equalizing element (10) faces an internal space (26), which is enclosed by the housing, and the head section (12) of the pressure equalizing element (10) faces a surrounding area (28) of the housing.

8. Motor vehicle having a battery according to Claim 7, wherein the battery is connected to a drive system of the motor vehicle.

## Revendications

1. Elément de compensation de pression (10) destiné à un boitier, compotant une section de tête (12) et une section de tronc (14) et un canal (16) perméable à l'air et s'étendant à travers la section de tête (12) et la section de tronc (14), **caractérisé en ce qu'**un élément de séchage (18) doté d'un dessiccateur éliminant l'humidité de l'air circulant dans le canal (16) est disposé dans le canal (16), dans lequel une soupape (20) est disposée dans le canal (16) dans la direction allant de la section de tête (12) à la section de tronc (14) à l'arrière de l'élément de séchage (18).

2. Elément de compensation de pression (10) selon la revendication 1, dans lequel l'élément de séchage (18) comporte un indicateur destiné à fournir une information concernant une capacité d'absorption du dessiccateur.

3. Elément de compensation de pression (10) selon la revendication 2, dans lequel l'indicateur est un capteur électronique qui peut être relié à un système de gestion électronique.

4. Elément de compensation de pression (10) selon la revendication 2, dans lequel l'indicateur présente un aspect variant en fonction de la capacité d'absorption du dessiccateur.

5. Elément de compensation de pression (10) selon la revendication 1, dans lequel la soupape (20) peut être commandée électroniquement et peut être reliée à un système de gestion.

6. Elément de compensation de pression (10) selon l'une quelconque des revendications 1 à 5, dans lequel au moins la section de tronc (14) présente un filetage extérieur et la section de tête (12) présente une configuration telle qu'une liaison par complémentarité de forme peut être établie avec un outil.

7. Batterie comportant un boîtier comportant une paroi de boîtier (24), dans laquelle un élément de compensation de pression (10) selon l'une quelconque des revendications 1 à 6 est disposé dans la paroi de boîtier (24), dans laquelle la section de tronc (14) de l'élément de compensation de pression (10) est tournée vers un espace intérieur (26) entouré par le boîtier et dans laquelle la section de tête (12) de l'élément de compensation de pression (10) est tournée vers un environnement (28) du boîtier.

8. Véhicule automobile comportant une batterie selon la revendication 7, dans lequel la batterie est reliée à un système de propulsion du véhicule automobile.
